# FASCICULE DE BREVET EUROPEEN

(11) **EP 3 155 651 B1**
(45) Date de publication et mention de la délivrance du brevet: **19.09.2018**
(21) Numéro de dépôt: 15736547.9
(22) Date de dépôt: 09.06.2015
(51) Int. Cl.: H01L 21/20, B32B 7/04, B32B 37/00, C09J 5/00

(54) **PROCÉDÉ DE COLLAGE DIRECT**
DIREKTKLEBEVERFAHREN
DIRECT ADHESION METHOD

(30) Priorité: 12.06.2014 FR 1455356
(43) Date de publication de la demande: 19.04.2017
(73) Titulaire: Commissariat à l'Énergie Atomique et aux Énergies Alternatives, 75015 Paris (FR)
(72) Inventeur: FOURNEL, Frank, F-38190 Villard-Bonnot (FR); RADISSON, Damien, F-38000 Grenoble (FR)
(74) Mandataire: Delorme, Nicolas
(86) Numéro de dépôt international: PCT/FR2015/051516
(87) Numéro de publication internationale: WO 2015/189513

(56) Documents cités:
- EP-A1- 0 383 391
- US-A1- 2012 193 009
- US-A1- 2012 329 241

## Description

La présente invention concerne un procédé de collage direct entre un substrat inférieur et un substrat supérieur.

Le collage direct est une technique utilisée de façon industrielle pour de nombreuses applications. Le collage direct est notamment utilisé dans la fabrication de SOI par Smart Cut™, pour l'élaboration d'imageurs rétro-éclairés et également dans les MEMS et NEMS. En général, ce collage qui ne nécessite pas l'ajout de matière adhésive entre les deux surfaces à coller, est réalisé à température ambiante et pression ambiante. Dans ces conditions, lorsque l'on place deux substrats, de silicium par exemple, l'un au-dessus de l'autre, le substrat supérieur est laissé libre au-dessus du substrat inférieur et se rapproche de ce dernier par gravité. Après quelques instants, les surfaces sont suffisamment proches pour que le collage direct s'enclenche à un endroit particulier de l'interface, qui est fonction de la topologie des surfaces des supports. Ce collage direct est notamment engagé par la présence de forces de Van der Waals entre les deux surfaces à coller. Une fois enclenché, le collage se propage de proche en proche en rapprochant les surfaces et en chassant l'air résiduel se trouvant entre les deux surfaces. Il est ainsi possible d'obtenir un collage direct de deux substrats de silicium de 300 mm de diamètre par simple gravité.

Toutefois, si aucun contrôle spécifique n'est opéré, la mise en contact des deux surfaces peut avoir lieu à deux endroits distincts et générer deux ondes de collage se propageant en même temps. Lorsque ces deux ondes de collage se rencontrent, de l'air est piégé à l'interface, ce qui génère un défaut de collage. Afin de pallier cet inconvénient, il est connu d'appliquer une pression locale sur le substrat supérieur afin de contrôler la position d'initiation du collage direct. Cette pression peut être maintenue afin de provoquer une déformation des surfaces, empêchant ainsi la naissance d'une onde de collage secondaire. Mais cette déformation doit cependant rester suffisamment faible pour ne pas empêcher la propagation de la première onde de collage.

Dans des machines automatiques de collage, cette pression est en général exercée au moyen d'un bras mécanique dont on contrôle la force ou alors par application d'un jet d'air dont la pression sur la surface du substrat supérieur est contrôlée. Cette méthode est complexe à mettre en oeuvre et peut parfois s'avérer inefficace. En effet, pour de nombreuses applications un collage sous vide est nécessaire, notamment dans le cas où des cavités sont présentes à l'interface de collage et dans lesquelles ne souhaite pas emprisonner de l'air. Mais, si le vide est suffisamment important, typiquement inférieur à 1 mbar, le collage direct est excessivement rapide. Le collage s'enclenche et se propage en effet dès que le substrat supérieur est libéré au-dessus du substrat inférieur, avant même que les systèmes mécaniques de contrôle (bras mécanique...) n'aient le temps d'être opérant. Ainsi, le point d'origine de l'onde de collage n'est pas contrôlé et la création d'une onde de collage secondaire peut apparaître.

Par ailleurs, il existe aussi des dispositifs qui ne relâchent pas librement le substrat supérieur au-dessus du substrat inférieur. Les surfaces à coller ne peuvent donc pas se déformer pour adapter mutuellement leur topologie jusqu'au niveau atomique, de sorte qu'il est difficile de réaliser un collage direct sans défaut de collage. Ces dispositifs sont ainsi très complexes à paramétrer et restent très onéreux.

Le document US2012/0329241 A1 décrit un procédé amélioré de collage direct entre deux substrats par le contrôle de l'initiation de l'onde de collage par application d'une pression locale, en vue d'éviter de générer une distorsion élastique locale des surfaces créant des contraintes non-uniformes des substrats collés.

Le document US2012/193009 décrit un dispositif et une méthode de collage direct utilisant l'application d'une pression locale P sur le substrat supérieur, avec une force prédéterminée de sorte à éviter le déplacement du substrat supérieur vis-à-vis du substrat inférieur et le désalignement des substrats lors de la mise en contact.

L'un des buts de l'invention consiste ainsi à contrôler la génération de l'onde de collage sous vide ou à pression ambiante, de sorte à empêcher l'apparition d'une onde de collage secondaire. A cet effet, la présente invention propose un procédé de collage direct entre un substrat inférieur et un substrat supérieur comprenant les étapes suivantes :
a) Fournir un support,
b) Positionner le substrat inférieur sur le support, le support étant configuré de sorte à surélever une portion du substrat inférieur,
c) Positionner le substrat supérieur au dessus du substrat inférieur,
d) Autoriser la chute par gravité du substrat supérieur sur le substrat inférieur de sorte à former un point de contact initial entre le substrat supérieur et le substrat inférieur, localisé sur la portion surélevée du substrat inférieur et,
e) Compléter la mise en contact du substrat supérieur et du substrat inférieur de sorte à coller le substrat supérieur et le substrat inférieur par collage direct.

Par l'expression « collage direct » on entend dans la présente demande un collage par adhésion moléculaire entre les deux substrats, en absence de colle ou d'adhésif.

Ainsi, grâce à la configuration du support formant une portion surélevée dans le substrat inférieur et à la disposition du substrat supérieur au dessus de la portion surélevée, la chute par gravité du substrat supérieur permet de choisir la localisation du point de contact initial entre le substrat supérieur et le substrat inférieur. L'initiation du collage est ainsi réalisée au niveau du point de contact initial et la propagation du collage est obtenue par la formation d'une seule onde de collage. En effet, cette configuration permet à l'air éventuellement présent entre les deux substrats à l'étape c) de s'échapper facilement et progressivement de part et d'autre de la portion surélevée, contrôlant ainsi la formation du point de contact initial et le départ de l'onde de collage. L'étape d) de chute du substrat supérieur par seule gravité selon l'invention offre une mise en oeuvre du procédé simple à réaliser par comparaison avec une technique de contrôle de l'initiation de l'onde de collage par application d'une pression locale. La méthode selon l'invention évite en effet le mouvement de pièces et permet de minimiser les défauts induits par l'application d'une pression locale.

Il est entendu dans le présent document que le support est configuré de sorte à surélever une portion du substrat inférieur par rapport à une deuxième portion du substrat inférieur.

La surélévation d'une portion du substrat inférieur suffit à permettre la réalisation de l'étape c) sous une atmosphère sous vide, et notamment sous une pression inférieure à 100 Pa, tout en prévenant l'apparition d'une onde de collage secondaire.

Selon une disposition, l'étape a) de fourniture d'un support comprend la fourniture d'un plateau et d'un élément de surélévation agencé sur le plateau, le plateau et l'élément de surélévation étant configurés pour déformer le substrat inférieur par gravité, de sorte à former ladite portion surélevée et une région d'inflexion dans le substrat inférieur à l'étape b).

Bien entendu, les amplitudes de la déformation du substrat inférieur par gravité et de la région d'inflexion sont limitées de sorte à rester compatible en termes de planéité avec les conditions pour obtenir un collage direct. Par exemple, une flèche classique qui ne perturbe pas le collage direct est de l'ordre de 30 micromètres pour un substrat de 200 mm de diamètre.

Il est également entendu dans le présent document que la déformation du substrat inférieur à l'étape b) du procédé reste dans le domaine de la déformation élastique de sorte que positionné sur une surface plane, le substrat inférieur déformé reprend sa planéité initiale ou sa flèche intrinsèque. La déformation du substrat inférieur, par rapport à sa géométrie initiale avant positionnement sur le plateau, prévient l'apparition d'une onde de collage secondaire, sous vide (typiquement une pression inférieure à 100 Pa) mais également lors d'un collage de l'étape d) réalisé sous une atmosphère supérieure ou égale au vide, notamment sous une pression comprise entre 100 Pa et 1013 hPa. En effet, en présence d'air entre les deux surfaces à coller et en l'absence de déformation du substrat inférieur, une fois la chute du substrat supérieur autorisée, ce dernier vient se positionner parallèlement au substrat inférieur et le collage peut ainsi s'initier à différents endroits. L'introduction de la déformation permet de localiser l'initiation au niveau de la portion surélevée. Ainsi, les défauts liés à la présence de bulles d'air emprisonnées à l'interface de collage provenant de la formation de plusieurs ondes de collage entre les deux substrats sont évités.

Afin de contrôler la déformation et la région d'inflexion du substrat inférieur, l'élément de surélévation a typiquement une hauteur comprise entre 0.05 et 3 fois l'épaisseur du substrat inférieur, et typiquement une épaisseur comprise entre 0.2 et deux fois l'épaisseur du substrat inférieur.

En variante et suivant le même objectif, l'élément de surélévation est configuré pour être réglable en hauteur et le procédé comprend avant l'étape d) une étape m) consistant à régler la hauteur de l'élément de surélévation. Cette configuration permet ainsi régler la hauteur de l'élément de surélévation de sorte à induire la déformation souhaitée du substrat inférieur, notamment une déformation supérieure ou égale à la flèche intrinsèque du substrat inférieur.

Selon une possibilité de réalisation, l'élément de surélévation s'étend à travers l'épaisseur du plateau. Il est ainsi possible de retirer l'élément de surélévation ou tout du moins de niveler son niveau à celui du plateau notamment une fois que l'onde de collage a été détectée.

Selon une variante, l'élément de surélévation est une cale amovible. Il est ainsi aisé de retirer la cale lorsque l'onde collage est générée.

Selon une autre variante, le plateau et l'élément de surélévation sont monoblocs. La mise en oeuvre du procédé selon l'invention est ainsi simple à réaliser dans la mesure où il n'est pas nécessaire de positionner un élément de surélévation sur un plateau ni de régler la hauteur de cet élément.

De préférence, le support fourni à l'étape a) comprend une portion de réception du substrat inférieur, la portion de réception étant plane, et l'étape c) comprenant le positionnement du substrat supérieur substantiellement parallèlement à la portion de réception du support.

Autrement dit, après l'étape b) le substrat comprend une surface de collage présentant un plan moyen compatible en termes de planéité avec les contraintes associées au collage direct et l'étape c) comprend le positionnement du substrat supérieur substantiellement parallèlement au plan moyen de la surface de collage du substrat inférieur.

Par l'expression 'substantiellement parallèlement' on entend dans la présente demande 'parallèle' ou 'formant un angle pouvant varier entre 0 et 5°. Ainsi, le parallélisme du substrat supérieur avec la portion de réception et la localisation du point de contact initial sur la portion surélevée du substrat inférieur sont toujours assurés que le collage soit effectué à pression atmosphérique, telle qu'environ 1013 hPa, ou sous vide et notamment sous une pression inférieure à 1 mbar. En effet, à pression ambiante, l'air entre les deux substrats forme un effet parachute lorsque le substrat supérieur chute par gravité. Ainsi, le substrat supérieur se place naturellement parallèlement à la portion surélevée du substrat inférieur, assurant la création d'une seule onde de collage. Dans ce dernier cas l'utilisation d'un angle un peu plus important est possible, l'angle peut notamment varier entre 0 et 15°. Mais lorsque le substrat chute par gravité et sous une pression réduite, et notamment sous une pression inférieure à 1 mbar, le réglage naturel du parallélisme entre les deux substrats n'est plus assuré de sorte que cette étape c) avec un angle variant entre 0 et 5° permet de conserver le contrôle de la localisation de l'onde de collage en l'absence d'air.

Selon une variante de réalisation, le procédé comprend avant l'étape b) une étape i) consistant à incliner le support par rapport à l'horizontale selon un angle d'inclinaison α. En cas de collage sous vide, cette inclinaison peut être suffisante à elle seule pour surélever une portion du substrat inférieur et permettre l'obtention d'une onde de collage unique. En cas de collage sous atmosphère ambiante, le substrat inférieur est non seulement déformé par gravité de part la présence de l'élément de surélévation mais il est également globalement incliné par rapport à l'horizontale selon l'angle α au moment de la formation du point de contact initial. Ainsi, pour une hauteur de l'élément de surélévation donnée, il est possible de mieux contrôler la déformation et la vitesse de rapprochement du substrat supérieur vis-à-vis du substrat inférieur incliné et de jouer sur l'impact de la force de gravité.

Typiquement, l'angle d'inclinaison (α) est supérieur à 0 et inférieur ou égal à 85°, de préférence, l'angle d'inclinaison (α) est supérieur à 0 et inférieur ou égal à 45°.

Selon une possibilité, l'étape i) consistant à incliner le support est réalisée en prévoyant un dispositif de réglage de l'angle d'inclinaison α du support. Le contrôle de l'angle d'inclinaison α peut alors être précis et réglé au cas par cas.

Selon une autre possibilité, l'étape i) consistant à incliner le support le positionnement d'un plot sous le support.

Selon une autre variante, le support fourni à l'étape a) comprend une portion de réception du substrat inférieur, la portion de réception étant globalement inclinée par rapport à l'horizontale selon un angle d'inclinaison α. Dans cette variante, le support est monobloc, il est formé d'une seule pièce dont une surface est inclinée.

Selon une disposition, le support comprend au moins une butée configurée de sorte qu'au moins une partie périphérique du substrat supérieur et au moins une partie périphérique du substrat inférieur sont alignées contre la butée, notamment à l'étape d) du procédé. Ceci est notamment utile pour faciliter le recouvrement au moins partiel du substrat inférieur et du substrat supérieur en particulier lorsque le support est incliné d'un angle d'inclinaison α par rapport à l'horizontale

De préférence, l'étape c) consiste à positionner le substrat supérieur au dessus du substrat inférieur de sorte que le substrat supérieur couvre au moins une partie du substrat inférieur.

De préférence encore, l'étape d) du procédé consiste à autoriser la chute par gravité du substrat supérieur sur le substrat inférieur de sorte que le point de contact initial entre le substrat supérieur et le substrat inférieur est localisé à l'aplomb de l'élément de surélévation.

Avantageusement, le procédé comprend une étape k) de détection de l'onde de collage entre le substrat supérieur et le substrat inférieur. Cette détection peut être réalisée par tout moyen adapté, tel qu'un capteur de pression disposé sur la portion surélevée du substrat inférieur avant le collage, un dispositif optique (notamment infrarouge), ou encore un dispositif acoustique....

De préférence, le procédé comprend après l'étape d) une étape l) comprenant un abaissement de la déformation du substrat inférieur lorsque l'onde de collage est détectée. On peut en effet considérer que la formation d'une onde de collage secondaire est peu probable une fois qu'au moins 10%, et de préférence plus de 50%, de la surface des substrats est collée.

Par l'expression « abaissement de la déformation du substrat inférieur » on entend dans le présent document l'aplanissement du substrat inférieur et le nivellement de la région d'inflexion.

Selon une possibilité, l'élément de surélévation est disposé sur le plateau de sorte à être sous-jacent à un bord périphérique du substrat inférieur. Le point de contact initial entre le substrat inférieur et le substrat supérieur est ainsi formé en un bord périphérique du susbtrat inférieur. L'onde de collage se propage ainsi à partir de ce bord périphérique. Le retrait de l'élément de surélévation est simple à réaliser une fois l'onde de collage initiée.

Selon une autre possibilité, l'élément de surélévation est disposé sur le plateau de sorte à être sous-jacent à une partie centrale du substrat inférieur. L'onde de collage se transmet ainsi tout autour du point de contact initial de sorte que la propagation de l'onde est centrosymétrique. Il est résulte que la durée nécessaire au collage de la totalité des sufaces des substrats est réduite par comparaison avec un positionnement de l'élement de surélevation sous un bord périphérique du substrat inférieur.

Selon une possibilité, l'élément de surélévation est mobile en translation de sorte à faciliter le réglage de sa hauteur.

Selon une variante, l'élément de surélévation comprend un filetage permettant de régler sa hauteur par vissage.

Selon une disposition, l'élément de surélévation comprend globalement la forme d'un doigt traversant l'épaisseur du plateau.

D'autres aspects, buts et avantages de la présente invention apparaîtront mieux à la lecture de la description suivante de différents modes de réalisation de celle-ci, donnée à titre d'exemples non limitatifs et faite en référence aux dessins annexés. Les figures ne respectent pas nécessairement l'échelle de tous les éléments représentés de sorte à améliorer leur lisibilité. Dans la suite de la description, par souci de simplification, des éléments identiques, similaires ou équivalents des différentes formes de réalisation portent les mêmes références numériques.
- Les figures 1 et 2 illustrent un collage direct selon un premier mode de réalisation de l'invention.
- La figure 3 illustre un collage direct selon une variante du premier mode de réalisation de l'invention.
- La figure 4 illustre un collage direct selon une autre variante du premier mode de réalisation de l'invention.
- La figure 5 illustre un collage direct selon un deuxième mode de réalisation de l'invention.
- La figure 6 illustre un collage direct selon une variante du deuxième mode de réalisation de l'invention.
- La figure 7 illustre un collage direct selon une autre variante du deuxième mode de réalisation de l'invention.
- La figure 8 illustre un collage direct selon encore une autre mode de réalisation de l'invention.
- La figure 9 illustre un collage direct selon une variante du mode de réalisation illustré à la figure 8.

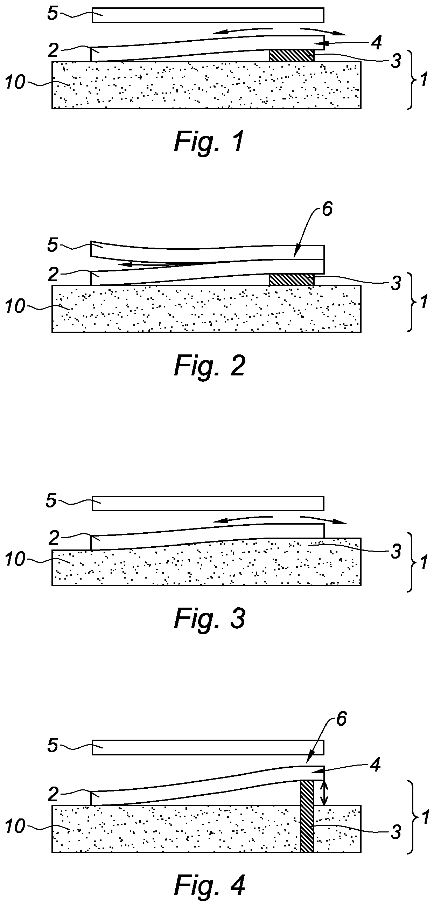

La figure 1 représente un support 1 sur lequel est positionné un substrat inférieur 2, tel qu'un substrat de silicium d'un diamètre de 200 mm et de 725 micromètres d'épaisseur préparé au collage (rugosité de surface inférieure à 0.2 nm RMS mesuré par AFM sur un champ de 5x5 micromètres et contamination particulaire inférieure à 20 particules dans une plage de diamètre allant de 90 à 500 nm mesurée par un détecteur de type Surfscan SP2). Le support 1 comprend un plateau 10 et un élément de surélévation 3, telle qu'une cale amovible de silicium d'une hauteur de 200 micromètres et comportant une base présentant des dimensions inférieures à celles du substrat inférieur 2 (typiquement inférieures de 20% voire 10% ou 5% à la surface du substrat inférieur) et de l'ordre de 10x10 mm. Cette cale 3 est intercalée entre le plateau 10 et le substrat inférieur 2 (étapes a et b). L'élément de surélévation 3 surélève ainsi une portion 4 du substrat inférieur 2 par rapport à une deuxième portion du substrat inférieur 2 en contact avec le plateau 10. Cette élévation conduit à une déformation par l'effet de la gravité et à la formation d'une région d'inflexion dans le substrat inférieur 2 par rapport à sa conformation initiale. Puis, un substrat supérieur 5, identique à celui du substrat inférieur 2, est positionné à l'aplomb du substrat inférieur 2 comme illustré à la figure 1 (étape c). Le substrat supérieur 5 est ensuite libéré de toute retenue, de sorte qu'il chute par gravité sur le substrat inférieur 2 déformé, sous une atmosphère ayant une pression typiquement compris entre 100Pa et 1013hPa. Comme illustré à la figure 2, le point de contact initial 6 des deux substrats 2,5 est localisé sur la portion surélevée 4 du substrat inférieur 2, à l'aplomb de l'élément de surélévation 3 de sorte à permettre un bon écoulement de l'air de part et d'autre du point de contact 6 initial (se référer aux flèches figure 1). Une caméra infrarouge permet de détecter l'initiation de l'onde de collage (non illustrée). L'onde de collage apparait après quelques dizaines de secondes et chasse l'air à partir du point de contact initial 6. La forme de l'écoulement de l'air, du fait de la déformation du substrat inférieur 2, prévient l'apparition d'une onde de collage secondaire. Une fois le collage initié, l'élément de surélévation 3 est retiré (non représenté -étape l) de sorte à obtenir le redressement du substrat inférieur 2 par abaissement de la portion surélevée 4, conduisant à un empilement des deux substrats collés 2,5 sensiblement plans.

Bien entendu, ce collage direct peut également être réalisé en variante sous une pression sous vide, notamment sous une pression inférieure à 100Pa sans générer d'onde de collage secondaire (non illustré).

La figure 3 illustre une variante de réalisation du procédé qui diffère du précédent mode de réalisation en ce que l'élément de surélévation 3 et le plateau 10 sont monoblocs. Le substrat inférieur 2 positionné sur le support 1 se déforme alors par gravité en suivant la conformation du support 1. Au cours de la chute du substrat supérieur 5, l'air est évacué de façon privilégiée au dessus de la portion surélevée 4 puis en amont de la propagation de l'onde de collage.

Selon une autre variante de réalisation illustrée à la figure 4, l'élément de surélévation 3 s'étend à travers l'épaisseur du plateau 10. L'élément de surélévation 3 est notamment configuré pour être réglable en hauteur, typiquement entre 1/5 et 2 fois l'épaisseur du substrat inférieur 2 de sorte à choisir une amplitude de déformation adaptée pour le collage direct sans création d'onde de collage secondaire. Cette possibilité de réglage peut être offerte par exemple par l'existence d'un filetage prévu sur un élément de surélévation 3 en forme de doigt et un filetage complémentaire dans un orifice ménagé dans le plateau 10 permettant le vissage ou le dévissage du doigt dans le plateau 10 (non illustré).

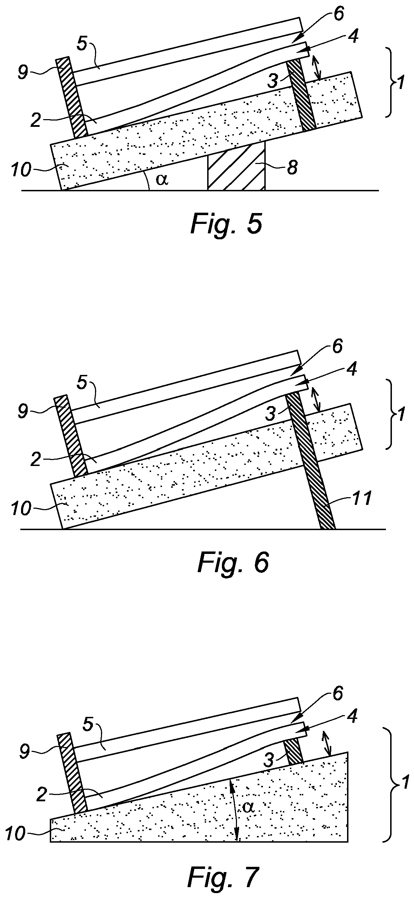

La figure 5 illustre un deuxième mode de réalisation du procédé dans lequel le plateau 10 est incliné par rapport à l'horizontale d'un angle α d'environ 10° par la présence d'un plot 8 (figure 5- étape i). Par ailleurs, un élément de surélévation 3 identique à celui décrit en relation avec la figure 4 assure l'obtention de la déformation et de la région d'inflexion dans le substrat inférieur 2. Dans ce deuxième mode de réalisation, le collage direct est réalisé sous vide à partir des substrats inférieur 2 et supérieur 5, préparés au collage de la même façon que celle décrite pour précédent le mode de réalisation. Le substrat supérieur 5 est positionné à l'aplomb du substrat inférieur 2 déformé (étape c). Il est maintenu substantiellement parallèlement à une portion de réception plane du support 1 par des éléments de calage (non représentés) de sorte que la localisation du point de contact initial 6 ait lieu sur la portion surélevée 4 du substrat inférieur 2. Comme illustré sur la figure 5 le support 1 comprend en outre une butée 9 permettant l'alignement des bords périphériques des substrats 2,5 à coller. Une fois le vide réalisé, les éléments de calage maintenant le substrat supérieur 5 en place sont retirés pour autoriser une chute par gravité. Le point de contact initial 6 a effectivement lieu sur la portion surélevée 4 du substrat inférieur 2 et le collage a lieu sans apparition d'onde de collage secondaire.

En variante, l'angle d'inclinaison α du support 1 par rapport à l'horizontale est choisi entre une valeur supérieure à 0 et inférieure ou égale à 85° et de préférence entre une valeur supérieure à 0 et inférieure ou égale à 45° de sorte à obtenir le surélèvement optimal de la portion 4 du substrat inférieur 2.

L'inclinaison du support 1 peut être obtenu en variante par un dispositif 11 de réglage de l'inclinaison situé par exemple dans le prolongement de l'élément de surélévation 3, tel qu'illustré figure 6.

Ce mode de réalisation générant une déformation et une région d'inflexion dans le substrat inférieur 2, il peut être également exécuté sous une pression supérieure à celle du vide, sans entraîner la formation d'une onde de collage secondaire.

Selon une autre variante de réalisation illustrée à la figure 7, l'inclinaison est obtenue par la conformation elle-même du support 1 qui comprend une portion de réception du substrat inférieur 2 globalement inclinée par rapport à l'horizontale selon l'angle α.

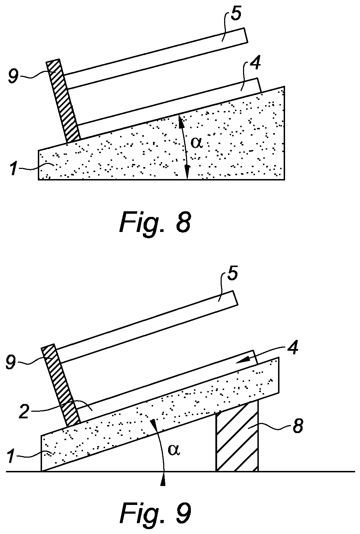

La figure 8 illustre un autre mode de réalisation qui diffère de précédents en ce que le support 1 n'est pas configuré pour générer une déformation et une région d'inflexion dans le substrat inférieur 2. En effet, le support 1 est incliné selon l'angle d'inclinaison α tel que précédemment défini, conduisant à former la région surélevée 4 dans le substrat inférieur 2. Il est alors possible de procéder au collage direct en faisant chuter par gravité le substrat supérieur 5 sous une atmosphère sous vide, typiquement inférieure à 100 Pa, tout en évitant la génération d'une onde de collage secondaire.

Comme illsutré aux figure 8 et 9, un tel support 1 présentant une surface de réception du substrat inférieur 2 inclinée peut être obtenu de diverses façons tel qu'en fournissant un support 1 présentant intrinsèquement l'angle d'inclinaison α ou en fournissant un support 1 sous lequel un plot 8 est positionné.

Ainsi, le procédé de l'invention propose un procédé de collage direct permettant l'initiation d'une seule onde de collage à une position déterminée. Ce procédé permet l'obtention d'un collage direct sous atmosphère ambiante ou sous vide, sans faire appel à un dispositif dédié pour l'application d'une pression locale, en utilisant la seule gravité pour opérer le contact entre les deux substrats. Par ailleurs, le procédé de l'invention permet également le contrôle de la localisation de l'initiation du collage sur la portion surélevé du substrat inférieur 2 et la prévention d'une onde de collage secondaire à basse pression notamment grâce au réglage du parallélisme entre le substrat supérieur 5 et celui du support 1. L'invention se soustrait ainsi de la problématique liée à la synchronisation de la chute du substrat supérieur 5 et de l'application de la pression locale déterminant le point de départ du collage des techniques connues.

Il va de soi que l'invention n'est pas limitée aux modes de réalisation décrits ci-dessus à titre d'exemples mais qu'elle comprend tous les équivalents techniques et les variantes des moyens décrits ainsi que leurs combinaisons.

## Revendications

1. Procédé de collage direct entre un substrat inférieur (2) et un substrat supérieur (5) comprenant les étapes suivantes :
a) Fournir un support (1),
b) Positionner le substrat inférieur (2) sur le support (1), le support (1) étant configuré de sorte à surélever une portion (4) du substrat inférieur (2),
c) Positionner le substrat supérieur (5) au dessus du substrat inférieur (2),
d) Autoriser la chute par gravité du substrat supérieur (5) sur le substrat inférieur (2) de sorte à former un point de contact (6) initial entre le substrat supérieur (5) et le substrat inférieur (2), localisé sur la portion surélevée (4) du substrat inférieur (2), et
e) Compléter la mise en contact du substrat supérieur (5) et du substrat inférieur (2) de sorte à coller le substrat supérieur (5) et le substrat inférieur (2) par collage direct.

2. Procédé de collage direct selon la revendication 1, dans lequel l'étape a) de fourniture d'un support (1) comprend la fourniture d'un plateau (10) et d'un élement de surélevation (3) agencé sur le plateau (10), le plateau (10) et l'élement de surélévation (3) étant configurés pour déformer le substrat inférieur (2) par gravité, de sorte à former ladite portion surélevée (4) et une région d'inflexion dans le substrat inférieur (2) à l'étape b).

3. Procédé de collage direct selon la revendication 2, dans lequel l'élément de surélévation (3) présente une hauteur comprise entre 0.05 et 3 fois l'épaisseur du substrat inférieur (2), et de préférence une hauteur comprise entre 0.2 et 2 fois l'épaisseur du substrat inférieur (2).

4. Procédé de collage direct selon l'une des revendications 2 à 3, dans lequel l'élément de surélévation (3) est configuré pour être réglable en hauteur et dans lequel le procédé comprend avant l'étape d) une étape m) consistant à régler la hauteur de l'élément de surélévation (3).

5. Procédé de collage direct selon l'une des revendications 2 à 4, dans lequel l'élément de surélévation (3) s'étend à travers l'épaisseur du plateau (10).

6. Procédé de collage direct selon l'une des revendications 2 à 4, dans lequel l'élément de surélévation (3) est une cale amovible.

7. Procédé de collage direct selon l'une des revendications 2 à 4, dans lequel le plateau (10) et l'élément de surélévation (3) sont monoblocs.

8. Procédé de collage direct selon l'une des revendications 1 à 7, dans lequel le support (1) fourni à l'étape a) comprend une portion de réception du substrat inférieur (2), la portion de réception étant plane, et dans lequel l'étape c) comprend le positionnement du substrat supérieur (5) substantiellement parallèlement à la portion de réception du support (1).

9. Procédé de collage direct selon l'une des revendications 1 à 8, comprenant une étape i) réalisée avant l'étape b) consistant à incliner le support (1) par rapport à l'horizontale selon un angle d'inclinaison (α).

10. Procédé de collage direct selon la revendication 9, dans lequel l'angle d'inclinaison (α) est supérieur à 0 et inférieur ou égal à 85°, de préférence, l'angle d'inclinaison (α) est supérieur à 0 et inférieur ou égal à 45°.

11. Procédé de collage direct selon l'une des revendications 1 à 10, dans lequel le support (1) comprend au moins une butée (9) configurée de sorte qu'au moins une partie périphérique du substrat supérieur (5) et au moins une partie périphérique du substrat inférieur (2) sont alignées contre la butée (9), notamment à l'étape d) du procédé.

12. Procédé de collage direct selon l'une des revendications 1 à 11 comprenant une étape k) de détection de l'onde de collage entre le substrat inférieur (2) et le substrat supérieur (5).

13. Procédé de collage direct selon la revendication 12 comprenant une étape l) comportant l'abaissement de la portion surélevée (4) du substrat inférieur (2) lorsque l'onde de collage est détectée.

14. Procédé de collage direct selon l'une des revendications 2 à 13, dans lequel l'étape d) est réalisée sous une atmosphère supérieure ou égale au vide, notamment sous une pression comprise entre 100 Pa et 1013 hPa.

15. Procédé de collage direct selon l'une des revendications 1 à 13, dans lequel l'étape c) est réalisée sous une atmosphère sous vide, et notamment sous une pression inférieure à 100 Pa.

## Patentansprüche

1. Direktverklebungsverfahren zwischen einem unteren Substrat (2) und einem oberen Substrat (5), umfassend die folgenden Schritte:
a) Bereitstellen eines Trägers (1),
b) Positionieren des unteren Substrats (2) auf den Träger (1), wobei der Träger konfiguriert ist, um einen Abschnitt (4) des unteren Substrats (2) zu erhöhen,
c) Positionieren des oberen Substrats (5) oberhalb des unteren Substrats (2),
d) Erlauben des Fallens durch die Schwerkraft des oberen Substrats (5) auf das untere Substrat (2), um einen anfänglichen Kontaktpunkt (6) zwischen dem oberen Substrat (5) und dem unteren Substrat (2) zu bilden, der sich auf dem erhöhten Abschnitt (4) des unteren Substrats (2) befindet, und
e) Vervollständigen des In-Kontakt-Bringens des oberen Substrats (5) und des unteren Substrats (2), um das oberen Substrat (5) und das untere Substrat (2) durch Direktverklebung zu verkleben.

2. Direktverklebungsverfahren nach Anspruch 1, wobei der Schritt a), das Bereitstellen eines Trägers (1), das Bereitstellen eines Plateaus (10) und eines auf dem Plateau (10) angeordneten Erhöhungselements (3) umfasst, wobei das Plateau (10) und das Erhöhungselement (3) konfiguriert sind, um das untere Substrat (2) durch Schwerkraft zu verformen, um in Schritt b) den erhöhten Abschnitt (4) und einen Flexionsbereich in dem unteren Substrat (2) zu bilden.

3. Direktverklebungsverfahren nach Anspruch 2, wobei das Erhöhungselement (3) eine Höhe im Bereich von 0,05 bis 3 mal die Dicke des unteren Substrats (2), und vorzugsweise eine Höhe im Bereich von 0,2 bis 2 mal die Dicke des unteren Substrats (2) aufweist.

4. Direktverklebungsverfahren nach einem der Ansprüche 2 bis 3, wobei das Erhöhungselement (3) konfiguriert ist, um höhenverstellbar zu sein und wobei das Verfahren vor dem Schritt d) einen Schritt m) umfasst, der aus dem Verstellen der Höhe des Erhöhungselements (3) besteht.

5. Direktverklebungsverfahren nach einem der Ansprüche 2 bis 4, wobei das Erhöhungselement (3) sich über die Dicke des Plateaus (10) erstreckt.

6. Direktverklebungsverfahren nach einem der Ansprüche 2 bis 4, wobei das Erhöhungselement (3) ein entfernbares Abstandsstück ist.

7. Direktverklebungsverfahren nach einem der Ansprüche 2 bis 4, wobei das Plateau (10) und das Erhöhungselement (3) einstückig sind.

8. Direktverklebungsverfahren nach einem der Ansprüche 1 bis 7, wobei der in Schritt a) bereitgestellte Träger (1) einen Aufnahmeabschnitt des unteren Substrats (2) umfasst, wobei der Aufnahmeabschnitt eben ist, und wobei der Schritt c) die Positionierung des oberen Substrats (5) im Wesentlichen parallel zum Aufnahmeabschnitt des Trägers (1) umfasst.

9. Direktverklebungsverfahren nach einem der Ansprüche 1 bis 8, umfassend einen Schritt i), durchgeführt vor Schritt b), der aus dem Neigen des Trägers (1), bezogen auf die Horizontale, gemäß einem Neigungswinkel (α) besteht.

10. Direktverklebungsverfahren nach Anspruch 9, wobei der Neigungswinkel (α) größer als 0 und kleiner oder gleich als 85° ist, vorzugsweise wobei der Neigungswinkel (α) größer als 0 und kleiner als 45° ist.

11. Direktverklebungsverfahren nach einem der Ansprüche 1 bis 10, wobei der Träger (1) mindestens ein Anschlagselement (9) umfasst, konfiguriert, damit mindestens ein Umfangsteil des oberen Substrats (5) und mindestens ein Umfangsteil des unteren Substrats (2) gegen das Anschlagselement (9) ausgerichtet sind, insbesondere in Schritt d) des Verfahrens.

12. Direktverklebungsverfahren nach einem der Ansprüche 1 bis 11, umfassend einen Schritt k) des Detektierens der Verklebungswelle zwischen dem unteren Substrat (2) und dem oberen Substrat (5).

13. Direktverklebungsverfahren nach Anspruch 12, umfassend einen Schritt l), beinhaltend das Absenken des erhöhten Abschnitts (4) des unteren Substrats (2), wenn die Verklebungswelle detektiert wird.

14. Direktverklebungsverfahren nach einem der Ansprüche 2 bis 13, wobei der Schritt d) unter einer Atmosphäre über oder gleich dem Vakuum durchgeführt wird, insbesondere unter einem Druck im Bereich von 100 Pa und 1013 hPa.

15. Direktverklebungsverfahren nach einem der Ansprüche 1 bis 13, wobei der Schritt c) unter einer Vakuum-Atmosphäre durchgeführt wird, und insbesondere unter einem Druck unterhalb von 100 Pa.

## Claims

1. A method for direct bonding between a lower substrate (2) and an upper substrate (5) comprising the following steps:
a) Providing a support (1),
b) Positioning the lower substrate (2) on the support (1), the support (1) being configured so as to raise a portion (4) of the lower substrate (2),
c) Positioning the upper substrate (5) above the lower substrate (2),
d) Authorizing the gravitational fall of the upper substrate (5) on the lower substrate (2) so as to form an initial contact point (6) between the upper substrate (5) and the lower substrate (2), located on the raised portion (4) of the lower substrate (2), and
e) Completing the contacting of the upper substrate (5) and of the lower substrate (2) so as to bond the upper substrate (5) and the lower substrate (2) by direct bonding.

2. The direct bonding method according to claim 1, wherein the step a) of providing a support (1) comprises providing a plate (10) and a raising member (3) arranged on the plate (10), the plate (10) and the raising member (3) being configured to deform the lower substrate (2) by gravity, so as to form said raised portion (4) and an inflection region in the lower substrate (2) in step b).

3. The direct bonding method according to claim 2, wherein the raising member (3) has a height comprised between 0.05 and 3 times the thickness of the lower substrate (2), and preferably a height comprised between 0.2 and 2 times the thickness of the lower substrate (2).

4. The direct bonding method according to any of claims 2 to 3, wherein the raising member (3) is configured to be adjustable in height and wherein the method comprises, prior to step d), a step m) consisting in adjusting the height of the raising member (3).

5. The direct bonding method according to any of claims 2 to 4, wherein the raising member (3) extends through the thickness of the plate (10).

6. The direct bonding method according to any of claims 2 to 4, wherein the raising member (3) is a removable wedge.

7. The direct bonding method according to any of claims 2 to 4, wherein the plate (10) and the raising member (3) are formed in one piece.

8. The direct bonding method according to any of claims 1 to 7, wherein the support (1) provided in step a) comprises a receiving portion of the lower substrate (2), the receiving portion being planar, and wherein the step c) comprises the positioning of the upper substrate (5) substantially parallel to the receiving portion of the support (1).

9. The direct bonding method according to any of claims 1 to 8, comprising a step i) carried out prior to step b) consisting in tilting the support (1) with respect to the horizontal according to an inclination angle (α).

10. The direct bonding method according to claim 9, wherein the inclination angle (α) is greater than 0 and smaller than or equal to 85°, preferably, the inclination angle (α) is greater than 0 and smaller than or equal to 45°.

11. The direct bonding method according to any of claims 1 to 10, wherein the support (1) comprises at least one stop (9) configured so that at least one peripheral part of the upper substrate (5) and at least one peripheral part of the lower substrate (2) are aligned against the stop (9), in particular in step d) of the method.

12. The direct bonding method according to any of claims 1 to 11 comprising a step k) of detecting the bonding wave between the lower substrate (2) and the upper substrate (5).

13. The direct bonding method according to claim 12 comprising a step I) including the lowering of the raised portion (4) of the lower substrate (2) when the bonding wave is detected.

14. The direct bonding method according to any of claims 2 to 13, wherein step d) is carried out under an atmosphere lower than or equal to vacuum, in particular under a pressure comprised between 100 Pa and 1013 hPa.

15. The direct bonding method according to any of claims 1 to 13, wherein step c) is carried out under a vacuum pressure, and in particular under a pressure lower than 100 Pa
